**Europäisches Patentamt**

**European Patent Office**

**Office européen des brevets**

(19)

(11) Veröffentlichungsnummer : **0 459 575 B1**

(12)

# EUROPÄISCHE PATENTSCHRIFT

(45) Veröffentlichungstag der Patentschrift :
22.11.95 Patentblatt 95/47

(51) Int. Cl.⁶ : **H01G 4/12**

(21) Anmeldenummer : **91201240.8**

(22) Anmeldetag : **27.05.91**

(54) **Verfahren zur Herstellung von Monolayer-Kondensatoren.**

(30) Priorität : **31.05.90 DE 4017518**

(43) Veröffentlichungstag der Anmeldung :
**04.12.91 Patentblatt 91/49**

(45) Bekanntmachung des Hinweises auf die
Patenterteilung :
**22.11.95 Patentblatt 95/47**

(84) Benannte Vertragsstaaten :
**DE FR GB**

(56) Entgegenhaltungen :
**EP-A- 0 297 823**

(73) Patentinhaber : **Philips Patentverwaltung
GmbH
Röntgenstrasse 24
D-22335 Hamburg (DE)**
(84) **DE**
Patentinhaber : **Philips Electronics N.V.
Groenewoudseweg 1
NL-5621 BA Eindhoven (NL)**
(84) **FR GB**

(72) Erfinder : **Brand, Hans-Wolfgang
Schlossparkstrasse 43
W-5100 Aachen (DE)**
Erfinder : **Klee, Mareike Katharine, Dr.
Randeratherweg 2
W-5142 Hückelhoven/Brachelen (DE)**
Erfinder : **de Vries, Johan Wilhelm Cornelis,
Dr.
J. Perkstraat 28
NL-5644 TK Eindhoven (NL)**
Erfinder : **Waser, Rainer Martin, Dr.
Am Schaafweg 9a
W-5100 Aachen (DE)**
Erfinder : **Wolters, Robertus Adrianus Maria,
Dr.
Ranonkelstraat 19
NL-5644 LA Eindhoven (NL)**

(74) Vertreter : **Volmer, Georg, Dipl.-Ing. et al
Philips Patentverwaltung GmbH,
Röntgenstrasse 24
D-22335 Hamburg (DE)**

## Beschreibung

Die Erfindung betrifft ein Verfahren zur Herstellung von Monolayer-Kondensatoren mit einer ferroelektrischen Schicht auf Titanat-Basis als Dielektrikum auf einem Substrat, wobei die ferroelektrische Schicht zwischen einer ersten und einer zweiten Edelmetall-Elektrode liegt.

Ferroelektrische Keramik, die als Hauptbestandteil z.B. $BaTiO_3$ enthält, wird aufgrund ihrer hohen Dielektrizitätskonstante als Dielektrikum von Kondensatoren eingesetzt.

Kondensatoren, die ferroelektrische Materialien wie z.B. $BaTiO_3$ enthalten, erfordern für eine Vielzahl von Anwendungen eine geringe Abhängigkeit der Kapazität von der Temperatur. Als Beispiel werden Kondensatoren mit X7R-Charakteristik genannt, bei denen $\Delta C/C(25\ °C) = \pm 15\%$ im Bereich zwischen -55 °C und +125 °C ist. Dazu müssen in das Bariumtitanat spezielle Dotierungen wie z.B. Nb und Co eingebracht werden. Derartige Kondensatoren werden heutzutage in einem Mehrschrittprozeß hergestellt, wobei $BaTiO_3$-Pulver mit der gewünschten Dotierung mit einem Bindemittel versetzt und zu Folien ausgezogen werden. Diese Folien werden abwechselnd zwischen Elektroden gestapelt, welche aufgrund der hohen Sintertemperatur der $BaTiO_3$-Keramik aus Pd, Pd/Ag-Legierungen oder Ni bestehen. Die aufeinandergestapelten Folien werden bei einer Temperatur von 1300 °C gesintert. Nach diesem Verfahren werden Vielschichtkondensatoren mit Dicken des keramischen Dielektrikums von 15-30 μm hergestellt, die infolge der Aufeinanderstapelung von bis zu 50 keramischen Schichten mit Flächen von 1-7 mm² Kapazitäten von bis zu 500 nF aufweisen. Dies bedeutet, daß jede keramische Schicht eine Flächenkapazität von 2-3 nF/mm² besitzt. Um bei diesem bekannten Prozeß Kondensatoren mit hohen Kapazitäten zu erreichen, muß die Korngröße der $BaTiO_3$-Keramik optimal eingestellt werden. Bei einer Korngröße von $\approx 0.7$ μm ist es möglich, $BaTiO_3$-Keramiken mit einer Dielektrizitätskontante $\varepsilon$ von 3000-4000 zu erhalten. Bei einer derartigen Korngröße der Keramik werden in den keramischen Schichten mit Schichtdicken von 15-30 μm relativ hohe Isolationswiderstände erhalten; bei 15 μm dicken Nb/Co-dotierten $BaTiO_3$-Keramikschichten wurden Isolationswiderstände von $10^9$-$10^{10}$ Ohm.m bei 5V/μm und 20°C gemessen.

Im Zuge der Miniaturisierung elektronischer Bauteile ist es wünschenswert, die Volumenkapazität von Kondensatoren zu erhöhen. Dies kann durch Verringerung der Dicke der dielektrischen Schichten erreicht werden. Weiter ist die direkte Integration eines Kondensators in integrierte Schaltungen mit Siliciumeinkristallplättchen wünschenswert, da dies eine erhebliche Reduzierung der Kosten bei der Installation der Bauteile und eine Verbesserung der elektrischen Eigenschaften durch Wegfall der mit den Zuleitungen verbundenen Leitungsinduktivitäten und -kapazitäten zur Folge hätte. Letzteres ist insbesondere bei der Anwendung der Bauelemente in elektronischen Rechnern von Vorteil.

Haupthindernis bei der Verringerung der dielektrischen Schichtdicke d auf Werte unter 15 μm ist die starke Abnahme des Isolationswiderstandes bei der Verwendung herkömmlicher keramischer Pulver, wie sie für die Herstellung von keramischen Folien eingesetzt werden.

So wurden beispielsweise bei Nb,Co-dotierten $BaTiO_3$-Keramikschichten mit einer Dicke von etwa 5 μm spezifische Widerstände von $10^8$ Ohm.m gemessen. Bei konstanter Spannung U (z.B. 5 V) ist die Abnahme des spezifischen Widerstandes noch stärker ausgeprägt. Ursache für die geringen Widerstände dünner $BaTiO_3$-Keramikschichten ist im wesentlichen die geringe Anzahl von Körnern zwischen den Elektroden. Es ist bekannt, daß der Isolationswiderstand in $BaTiO_3$-Keramik hauptsächlich durch die sehr hochohmigen Korngrenzen bestimmt wird. Wird nun die Schichtdicke erniedrigt, während die Korngröße unverändert bleibt, so nimmt naturgemäß die Anzahl der Korngrenzen zwischen den Elektroden ab. Dies wirkt sich nachteilig auf den Isolationswiderstand der Schicht aus.

Ebenfalls durch die Korngrenzen bestimmt ist die Lebensdauer der Bauteile, die in erster Linie durch gleichspannungsinduzierte Degradation bestimmt wird; die Lebensdauer nimmt mit zunehmender Feldstärke (durch Verringerung der Schichtdicke d bei gleicher maximaler Nennspannung U) überproportional ab.

Es ist versucht worden, sowohl das Problem des geringen Isolationswiderstandes, als auch das Problem der verminderten Lebensdauer dünner $BaTiO_3$-Keramikschichten durch eine Verringerung der Korngröße in diesen Schichten zu beheben.

Aus J.Appl.Phys. 55 (1984) S. 3706 ff ist es z.B. bekannt, Kathodenzerstäubungsverfahren einzusetzen, um Bariumtitanatschichten abzuscheiden. Das Kathodenzerstäubungsverfahren hat jedoch den Nachteil, daß es zum einen technisch sehr aufwendig ist und daß darüberhinaus die gezielte Abscheidung mehrkomponentiger Schichten mit gewünschter Stöchiometrie nur sehr schwierig möglich ist.

Außerdem sind Reaktionstemperaturen im Bereich von 900-1200 °C notwendig, um kristalline $BaTiO_3$-Schichten mit hohen Kapazitäten herzustellen. Diese Reaktionstemperaturen sind für die Integration eines Kondensators in eine Siliciumeinkristallscheibe zu hoch. Nach dem bekannten Verfahren wurden 2,5 μm dicke $BaTiO_3$-Schichten auf Pt-Substraten abgeschieden. Für die bei einer Temperatur von 1200 °C behandelten Schichten wurde eine Flächenkapazität von 25 nF/mm² und ein Isolationswiderstand von $10^7$ Ohm.m bei 0,4 V/µm gemessen.

Aus US-PS 3 002 861 ist es bekannt, chemische Beschichtungsmethoden zur Herstellung von Bariumtitanatschichten, ausgehend von Barium- und Titanalkoxidlösungen, einzusetzen. Diese Ausgangsstoffe haben jedoch den Nachteil, daß besonders das Bariumalkoxid sehr hydrolyseempfindlich ist und eine reproduzierbare Abscheidung von Bariumtitanatschichten schwierig ist. Ein weiterer Nachteil ist, daß die auf diese Weise gebildeten Schichten mehrphasig sind und neben $BaTiO_3$ auch $Ba_2TiO_4$ und $BaTiO_5$ enthalten.

Aus Am.Cer.Soc.Bull.55 (1976), Seite 1064 ff ist es bekannt, ausgehend von Bariumnaphthenat- und Titanalkoxidlösungen, 1-2 µm dicke Bariumtitanatschichten auf Glas- oder Quarzglassubstraten für die Anwendung bei IR-Spektralanalysen abzuscheiden. Die bei einer Temperatur im Bereich von 200-800°C thermisch zersetzten Schichten zeigen für Schichten einer Schichtdicke > 1 µm eine Korngröße von 0,5 µm. Anhand der Untersuchungen, die zur vorliegenden Erfindung geführt haben, ist festzustellen, daß eine Korngröße von 0,5 µm für eine 1-2 µm dicke Schicht zu groß ist, da dann die Zahl der Korngrenzen pro Schicht zu gering ist; die Werte für den Isolationswiderstand werden damit zu niedrig.

Der Erfindung liegt die Aufgabe zugrunde, ein chemisches Beschichtungsverfahren anzugeben, mit dem Monolayer-Kondensatoren mit dielektrischen Schichten auf Titanat-Basis auf einfache Weise hergestellt werden können, die eine relativ hohe Flächenkapazität, eine geringe Temperaturabhängigkeit ihrer Werte für die Dielektrizitätskonstante und den dielektrischen Verlustfaktor und einen relativ hohen Isolationswiderstand aufweisen.

Diese Aufgabe wird erfindungsgemäß dadurch gelöst, daß die ferroelektrische Schicht in Form einer Bariumtitanat-Schicht mit einer Schichtdicke im Bereich von 0,2 bis 0,6 µm dadurch ausgebildet wird, daß eine stabile Lösung von Salzen von Carbonsäuren, Alkoxiden und/oder Acetylacetonaten aufgebracht und thermisch bei Temperaturen im Bereich von 500 bis 700 °C zersetzt wird, wobei die die ferroelektrische Schicht bildende Lösung so eingestellt wird, daß sich nach dem thermischen Zersetzungsprozeß ein Titanoxid-Überschuß von etwa 1 Mol% ergibt und wobei dieser Beschichtungsprozeß wiederholt wird, bis die gewünschte Schichtdicke erreicht ist, wonach auf der ferroelektrischen Schicht die zweite Edelmetallelektrode angebracht wird.

Überraschenderweise wurde nun gefunden, daß durch dieses chemische Beschichtungsverfahren ferroelektrische Schichten hergestellt werden können, die eine mittlere Kristallitgröße von nur $\leqq 0,1$ µm aufweisen, wenn sie auf einem Substrat abgeschieden werden, das keine chemischen Grenzflächenreaktionen mit dem Material der ferroelektrischen Schicht zeigt (dies gilt z.B. für Edelmetalle, wie sie als Kondensatorelektroden eingesetzt werden) und wenn nach dem thermischen Zersetzungsprozeß ein Titanoxid-Überschuß von etwa 1 Mol% vorhanden ist. Damit sind nach dem erfindungsgemäßen Verfahren Monolayer-Kondensatoren herstellbar, die aufgrund der relativ kleinen Kristallitgröße der ferroelektrischen Schicht ausreichend hohe Werte für den Isolationswiderstand aufweisen.

Nach einer vorteilhaften Weiterbildung des Verfahrens gemäß der Erfindung wird die Lösung unter Einsatz mindestens eines Salzes einer Carbonsäure und mindestens eines Alkoxids oder unter Einsatz mindestens eines Salzes einer Carbonsäure und mindestens eines Alkoxids und/oder mindestens eines Acetylacetonats hergestellt.

Nach einer weiteren Ausbildung des erfindungsgemäßen Verfahrens werden zweiwertige Ionen in Form von Salzen von Carbonsäuren und drei- und/oder höherwertige Ionen in Form von Alkoxiden oder Acetylacetonaten in die Lösung eingeführt.

Nach einer vorteilhaften Weiterbildung des erfindungsgemäßen Verfahrens wird die ferroelektrische Schicht auf der ersten Elektrode in Form einer auf dem Substrat angebrachten Edelmetallschicht oder in Form einer polierten Edelmetallscheibe als Substrat ausgebildet.

Nach einer weiteren vorteilhaften Ausgestaltung des Verfahrens gemäß der Erfindung wird als Substrat ein mehrschichtiges Substrat eingesetzt, in Form einer einkristallinen Siliciumscheibe, auf der eine Zwischenschicht in Form einer Oxidschicht und darauf eine Edelmetall-Elektrodenschicht als erste Elektrode abgeschieden werden, wobei zwischen der Oxidschicht und der Elektrodenschicht eine die Haftung des Elektrodenmetalls begünstigende Haftschicht angebracht wird.

Nach einer vorteilhaften weiteren Ausbildung des Verfahrens gemäß der Erfindung wird die die ferroelektrische Schicht bildende Lösung durch Tauchen oder Schleudern auf die erste Elektrode aufgebracht. Hiermit ist der Vorteil verbunden, daß die in der Lösung vorgegebenen Zusammensetzungsverhältnisse in der hergestellten Schicht reproduzierbar erhalten bleiben.

Mit der Erfindung ist der Vorteil verbunden, daß sich besonders hohe Werte für den Isolationswiderstand reproduzierbar erreichen lassen. Außerdem ist mit dem Titanoxidüberschuß der weitere Vorteil verbunden, daß die Ausbildung der Phase $Ba_2TiO_4$ mit Sicherheit unterbunden wird. Durch die Abwesenheit der feuchtigkeitsempfindlichen Phase $Ba_2TiO_4$ ergibt sich hinsichtlich des Isolationswiderstandes eine hohe Langzeitstabilität.

Mit der Erfindung sind die weiteren Vorteile verbunden, daß die relativ geringen Reaktionstemperaturen zum thermischen Zersetzen der aus den Lösungen abgeschiedenen Schichten es ermöglichen, einen Kondensator in eine integrierte Schaltung auf einem Silicium-Chip zu integrieren, ohne den Chip thermisch zu beeinträchtigen. Ein weiterer Vorteil der mit dem erfindungsgemäßen Verfahren hergestellten dielektrischen Schichten ist, daß aufgrund der relativ geringen Schichtdicken der dielektrischen Schichten Kondensatoren mit relativ hohen Kapazitäten (bis zu etwa 30 nF/mm$^2$) hergestellt werden können. Ausgehend von Reaktionstemperaturen im Bereich von 500 bis 700 °C ist es möglich, Schichten mit sehr kleiner Kristallitgröße, nämlich einer Kristallitgröße $\leq 0,1$ µm, abzuscheiden. Durch die Feinkörnigkeit der Schichten kann in den dielektrischen Schichten und damit in den mit ihnen aufgebauten Kondensatoren ein flacher Verlauf der Kapazität mit der Temperatur erreicht werden, ohne daß spezielle Dotierungen eingebracht werden müssen. Im Falle von erfindungsgemäß hergestellten BaTiO$_3$-Schichten ist die relative Änderung der Kapazität als Funktion der Temperatur innerhalb eines Temperaturbereiches von -50 bis +125 °C nicht größer als 6%.

Die nach dem erfindungsgemäßen Verfahren hergestellten relativ feinkörnigen Schichten haben den weiteren Vorteil, daß trotz der geringen Schichtdicke aufgrund der sehr feinkörnigen Kristallite eine Vielzahl von Korngrenzen erzeugt wird, wodurch ferroelektrische Schichten mit relativ hohen Isolationswiderständen erhalten werden.

Im weiteren werden Ausführungsbeispiele der Erfindung beschrieben und in ihrer Wirkungsweise erläutert.

A.

4,3790 g Titan-tetra-butylat und 14,1479 g Bariumnaphthenat (gelöst in Testbenzin; 12,38 Gew.% Ba) werden in 42 ml Butanol vermischt. Die homogene Ba-Ti-Lösung wird durch ein Celluloseacetatfilter mit einer Porenweite von 0,2 µm filtriert.

Auf Si-Einkristall(100)-Substraten wird durch thermische Oxidation eine dünne SiO$_2$-Schicht erzeugt. Anschließend wird eine 10 nm dicke Ti-Schicht und eine 33 nm dicke Pt-Schicht mittels Kathodenzerstäubung aufgebracht. Dazu werden Platin und Titan bei einem Argondruck von 6,7.10$^{-3}$ mbar zunächst über eine Dauer von 30 min bei einer Leistung von 300 W vorzerstäubt. Die Abscheidung einer 10 nm dicken Ti- und einer 33 nm dicken Pt-Schicht erfolgt bei 300 W jeweils innerhalb von 7 bzw. 14 min. Die auf diese Weise erhaltenen Substrate werden mit Salpetersäure, deionisiertem Wasser und anschließend mit Isopropanol von Staubpartikeln gereinigt. Die Substrate werden anschließend über eine Dauer von 6 h bei einer Temperatur von 700 °C getempert.

Auf die nach diesem Verfahren erhaltenen Substrate werden jeweils 70 µl der oben beschriebenen Ba-Ti-Lösung aufgebracht. Die Flüssigkeit wird durch Schleudern mit 200 Umdrehungen/min während einer Dauer von 3 s auf den Substraten verteilt, der Überschuß wird anschließend mit 1000 Umdrehungen/min (Tabelle I, Probe Nr. 1), 2000 Umdrehungen/min (Tabelle I, Proben Nr. 2 und 4) und 2500 Umdrehungen/min (Tabelle I, Proben Nr. 3 und 5) innerhalb von 27 s abgeschleudert. Anschließend werden die Schichten in einem Rohrofen mit einer Heizgeschwindigkeit von 350 K/h auf eine Temperatur von 700 °C im Sauerstoffstrom aufgeheizt, über eine Dauer von 3 h bei 700 °C getempert und anschließend mit 350 K/h auf Raumtemperatur abgekühlt.

Der hier beschriebene Beschichtungsprozeß wird viermal (Proben Nr. 1,2 und 3) bzw. siebenmal (Proben Nr. 4 und 5) wiederholt. Die nach diesem Verfahren auf Si-Einkristallen abgeschiedenen BaTiO$_3$-Schichten haben eine Schichtdicke im Bereich von 0,23 µm bis 0,4 µm. Die Schichten sind unter den hier abgeschiedenen Bedingungen kristallin, wobei aufgrund der niedrigen Reaktionstemperaturen sehr feinkörnige Schichten erhalten werden. Wie rastermikroskopischen Aufnahmen entnommen werden kann, ist die Korngröße bedeutend kleiner als 0,1 µm. Aufgrund der sehr feinkörnigen BaTiO$_3$-Kristallite werden sehr breite Röntgenbeugungsreflexe beobachtet.

Zur Herstellung dünner BaTiO$_3$-Kondensatoren werden 100 Goldelektroden mit einer Fläche von 1mm$^2$ auf die BaTiO$_3$-Schichten aufgedampft. Die dielektrischen Werte und die Werte für den spezifischen Isolationswiderstand $\rho$ für die Proben Nr. 1 bis 5 ergeben sich aus Tabelle II.

Messungen der Kapazität an den 100 Kondensatoren bei 0,5 V/1kHz zeigten eine Flächenkapazität im Bereich von 15,4 nF/mm$^2$ bis 29,20 nF/mm$^2$. Die dielektrischen Verluste liegen im Bereich von 3,8% bis 6,7%. Messungen der Kapazität in Abhängigkeit von der Temperatur (-55 °C bis +125 °C) zeigen für die abgeschiedenen Schichten aufgrund der Feinkörnigkeit eine sehr flache Charakteristik. Bei -55 °C ist $\Delta C/C(25\ °C) = -6\%$, bei 125 °C ist $\Delta C/C(25\ °C) = -3\%$.

Der spezifische Isolationswiderstand $\rho$, gemessen bei Raumtemperatur, beträgt $1.10^{10}$ bis $2.10^{10}$ Ohm.m (Probe Nr. 1), $4.10^9$ bis $5.10^9$ Ohm.m (Proben Nr. 2 und 3), $1.10^{10}$ bis $1,5.10^{10}$ Ohm.m (Probe Nr. 4) und $4.10^9$ bis $5.10^9$ Ohm.m (Probe Nr. 5) in einem elektrischen Feld von 1 V/µm. In einem Feld von 5 V/µm beträgt der spezifische Isolationswiderstand $4.10^9$ bis $5.10^9$ Ohm.m (Probe Nr. 1), $4.10^8$ bis $6.10^8$ Ohm.m (Proben Nr. 2 und 3), $4.10^9$ bis $5.10^9$ Ohm.m (Probe Nr. 4) und $2.10^9$ bis $3.10^9$ Ohm.m (Probe Nr. 5).

B.

70 μl Ba-Ti-Lösung werden auf Si-Substrate (entsprechend Ausführungsbeispielen unter A.) aufgebracht. Die Lösungen werden durch Schleudern mit 200 Umdrehungen/min über eine Dauer von 3 s auf den Substraten verteilt. Der Überschuß der Flüssigkeit wird anschließend bei 2000 Umdrehungen/min (Tabelle I, Probe Nr. 6) bzw. bei 2500 Umdrehungen/min (Tabelle I, Probe Nr. 7) innerhalb einer Dauer von 27 s abgeschleudert. Anschließend werden die Schichten mit einer Aufheizgeschwindigkeit von 350 K/h auf eine Temperatur von 700 °C im Sauerstoffstrom aufgeheizt, über eine Dauer von 3 h bei dieser Temperatur getempert und mit 350 K/h auf Raumtemperatur abgekühlt. Der hier beschriebene Beschichtungsprozeß wird dreimal wiederholt. Im fünften Beschichtungsprozeß werden die Schichten über eine Dauer von 12 h bei einer Temperatur von 700 °C im Sauerstoffstrom getempert.

Zur Herstellung von dünnen $BaTiO_3$-Kondensatoren werden 100 Goldelektroden mit einer Fläche von 1mm$^2$ auf die $BaTiO_3$-Schichten aufgedampft. Die dielektrischen Werte und die Werte für den spezifischen Isolationswiderstand $\rho$ für die Proben Nr. 6 und 7 ergeben sich aus Tabelle II.

Messungen der Kapazität an den 100 Kondensatoren bei 0,5 V/1 kHz zeigten eine Flächenkapazität von 20,3 nF/mm$^2$ (Probe Nr. 6) und 24,6 nF/mm$^2$ (Probe Nr. 7). Die dielektrischen Verluste betragen 4,5 bis 5,4%.

Der spezifische Isolationswiderstand $\rho$ beträgt bei Raumtemperatur $2.10^{10}$ bis $2,5.10^{10}$ Ohm.m (Probe Nr. 6) und $1.10^{10}$ bis $1,5.10^{10}$ Ohm.m (Probe Nr. 7) in einem elektrischen Feld von 1 V/μm sowie $6.10^9$ bis $1,5.10^9$ Ohm.m (Probe Nr. 6) und $4.10^9$ bis $6.10^9$ Ohm.m (Probe Nr. 7) in einem Feld von 5 V/μm.

C.

Ein poliertes Pt-Substrat wird zur Beschichtung in eine Ba-Ti-Lösung (siehe Ausführungsbeispiele unter A.) getaucht und mit einer Geschwindigkeit von 0,4 cm/s aus der Lösung herausgezogen. Die Schicht wird in einem Ofen innerhalb einer Dauer von 30 min auf eine Temperatur von 1200 °C aufgeheizt, über eine Dauer von 1 h bei dieser Temperatur getempert und mit 350 K/h auf Raumtemperatur abgekühlt. Der hier beschriebene Beschichtungsprozeß wird einmal wiederholt. Bei den folgenden zwölf Beschichtungen, die wie oben beschrieben durchgeführt werden, wird die Schicht zur Zersetzung der organischen Bestandteile und zur Bildung der Oxide und flüchtigen Carbonate über eine Dauer von 1 h bei einer Temperatur von 500 °C getempert und mit 250 K/h abgekühlt. Zur Bildung von $BaTiO_3$ wird die Schicht mit einer Aufheizgeschwindigkeit von 330 K/h auf 1000 °C aufgeheizt und bei dieser Temperatur über eine Dauer von 1 h getempert. Die Abkühlung auf Raumtemperatur erfolgt mit einer Geschwindigkeit von 330 K/h. Die nach diesem Verfahren auf dem Pt-Substrat abgeschiedene kristalline $BaTiO_3$-Schicht ist etwa 1 μm dick und weist eine mittlere Korngröße von 0,1 μm auf (siehe Tabelle I, Probe Nr. 8).

Zur Herstellung eines dünnen $BaTiO_3$-Kondensators werden Goldelektroden mit einer Fläche von 9,4 mm$^2$ auf die $BaTiO_3$-Schicht aufgedampft. Die dielektrischen Werte und die Werte für den spezifischen Isolationswiderstand $\rho$ für die Probe Nr. 8 ergeben sich aus Tabelle II.

Messungen der Kapazität bei 1 V/1kHz zeigten eine Flächenkapazität von 5,5 nF/mm$^2$ und dielektrische Verluste von 3,6 %.

Der spezifische Isolationswiderstand $\rho$ ist bei Raumtemperatur $1.10^{11}$ bis $2.10^{11}$ Ohm.m in einem elektrischen Feld von 1 V/μm und $5.10^{10}$ bis $7.10^{10}$ Ohm.m in einem Feld von 5 V/μm.

Tabelle I.

| Probe Nr. | Umdrehungszahl/ Umdrehungsdauer (U/min/s) | Tempertemperatur/ Temperdauer (°C /h) | Anzahl der Beschichtungen | Schicht- dicke (µm) |
|---|---|---|---|---|
| 1 | 200/3 + 1000/27 | 700/3 | 5 | 0,4 |
| 2 | 200/3 + 2000/27 | 700/3 | 5 | 0,26 |
| 3 | 200/3 + 2500/27 | 700/3 | 5 | 0,23 |
| 4 | 200/3 + 2000/27 | 700/3 | 8 | 0,39 |
| 5 | 200/3 + 2500/27 | 700/3 | 8 | 0,35 |
| 6 | 200/3 + 2000/27<br>200/3 + 2000/27 | 700/3<br>700/12 | 4 )<br>1 ) 5 | 0,3 |
| 7 | 200/3 + 2500/27<br>200/3 + 2500/27 | 700/3<br>700/12 | 4 )<br>1 ) 5 | 0,26 |
| 8 | getaucht | 1200/1 | 14 | 1,0 |

Tabelle II.

| Probe Nr. | C (nF/mm$^2$) | tg $\delta$ (%) | $\varrho$ 1 V/$\mu$m (Ohm.m) | $\varrho$ 5 V/$\mu$m (Ohm.m) |
|---|---|---|---|---|
| 1 | 16,1 | 4,6 | $1.10^{10}$–$2.10^{10}$ | $4.10^9$–$5.10^9$ |
| 2 | 29,2 | 6,7 | $4.10^9$ –$5.10^9$ | $4.10^8$–$6.10^8$ |
| 3 | 27,8 | 5,8 | $4.10^9$ –$5.10^9$ | $4.10^8$–$6.10^8$ |
| 4 | 15,4 | 3,8 | $1.10^{10}$–$1,5.10^{10}$ | $4.10^9$–$5.10^9$ |
| 5 | 19,3 | 4,8 | $4.10^9$ –$5.10^9$ | $2.10^9$–$3.10^9$ |
| 6 | 20,3 | 4,5 | $2.10^{10}$–$2,5.10^{10}$ | $6.10^9$–$1,5.10^9$ |
| 7 | 24,6 | 5,4 | $1.10^{10}$–$1,5.10^{10}$ | $4.10^9$–$6.10^9$ |
| 8 | 5,5 | 3,6 | $1.10^{11}$–$2.10^{11}$ | $5.10^{10}$–$7.10^{10}$ |

C = Flächenkapazität bei 25 °C
tg $\delta$ = diel. Verlustfaktor
$\varrho$ = spez. Isolationswiderstand bei 25 °C

**Patentansprüche**

1. Verfahren zur Herstellung von Monolayer-Kondensatoren mit einer ferroelektrischen Schicht auf Titanat-Basis als Dielektrikum auf einem Substrat, wobei die ferroelektrische Schicht zwischen einer ersten und einer zweiten Edelmetall-Elektrode
liegt,
dadurch gekennzeichnet,
daß die ferroelektrische Schicht in Form einer Bariumtitanat-Schicht mit einer Schichtdicke im Bereich von 0,2 bis 0,6 $\mu$m dadurch ausgebildet wird, daß eine stabile Lösung von Salzen von Carbonsäuren, Alkoxiden und/oder Acetylacetonaten aufgebracht und thermisch bei Temperaturen im Bereich von 500 bis 700 °C zersetzt wird, wobei die die ferroelektrische Schicht bildende Lösung so eingestellt wird, daß sich nach dem thermischen Zersetzungsprozeß ein Titanoxid-Überschuß von etwa 1 Mol% ergibt und wobei dieser Beschichtungsprozeß wiederholt wird, bis die gewünschte Schichtdicke erreicht ist, wonach auf der ferroelektrischen Schicht die zweite Edelmetallelektrode angebracht wird.

2. Verfahren nach Anspruch 1,
dadurch gekennzeichnet,
daß die Lösung unter Einsatz mindestens eines Salzes einer Carbonsäure und mindestens eines Alkoxids oder unter Einsatz mindestens eines Salzes einer Carbonsäure und mindestens eines Alkoxids und/oder mindestens eines Acetylacetonats hergestellt wird.

3. Verfahren nach den Ansprüchen 1 und 2,
dadurch gekennzeichnet,

daß zweiwertige Ionen in Form von Salzen von Carbonsäuren und drei- und/oder höherwertige Ionen in Form von Alkoxiden oder Acetylacetonaten in die Lösung eingeführt werden.

4. Verfahren nach mindestens einem der Ansprüche 1 bis 3,
dadurch gekennzeichnet,
daß die ferroelektrische Schicht auf der ersten Elektrode in Form einer auf einem Substrat angebrachten Edelmetallschicht oder in Form einer polierten Edelmetallscheibe als Substrat ausgebildet wird.

5. Verfahren nach Anspruch 4,
dadurch gekennzeichnet,
daß als Substrat ein mehrschichtiges Substrat eingesetzt wird, in Form einer einkristallinen Siliciumscheibe, auf der eine Zwischenschicht in Form einer Oxidschicht und darauf eine Edelmetall-Elektrodenschicht als erste Elektrode abgeschieden werden, wobei zwischen der Oxidschicht und der Elektrodenschicht eine die Haftung des Elektrodenmetalls begünstigende Haftschicht angebracht wird.

6. Verfahren nach Anspruch 5,
dadurch gekennzeichnet,
daß die Oxidschicht auf dem einkristallinen Silicium-Substrat durch thermische Oxidation erzeugt wird.

7. Verfahren nach den Ansprüchen 1 bis 6,
dadurch gekennzeichnet,
daß als Elektrodenmetall für die erste Elektrode Platin eingesetzt wird.

8. Verfahren nach Anspruch 7,
dadurch gekennzeichnet,
daß eine Titanschicht als Haftschicht für die Elektrodenschicht angebracht wird.

9. Verfahren nach mindestens einem der Ansprüche 1 bis 8,
dadurch gekennzeichnet,
daß die die ferroelektrische Schicht bildende Lösung durch Tauchen oder Schleudern auf die erste Elektrode aufgebracht wird.

10. Verfahren nach mindestens einem der Ansprüche 1 bis 9,
dadurch gekennzeichnet,
daß für die die ferroelektrische Schicht bildende Lösung Titan-tetra-butylat und Barium-naphthenat eingesetzt werden.

11. Verfahren nach mindestens einem der Ansprüche 1 bis 10,
dadurch gekennzeichnet,
daß die zweite Elektrode durch eine Goldschicht gebildet wird.

## Claims

1. A method of manufacturing monolayer capacitors having a ferroelectric layer on the basis of titanate as a dielectric on a substrate, the ferroelectric layer being located between a first and a second noble metal electrode, characterized in that the ferroelectric layer is obtained in the form of a barium titanate layer having a layer thickness in the range of from 0.2 to 0.6 $\mu$m by applying a stable solution of salts of carboxylic acids, alkoxides and/or acetyl acetonates and thermally decomposing it at temperatures in the range of from 500 to 700°C, the solution constituting the ferroelectric layer being adjusted so that after the thermal decomposition process an excess quantity of titanium oxide of about 1 mol.% is obtained, and this coating process being repeated until the desired layer thickness is obtained, after which the second noble metal electrode is provided on the ferroelectric layer.

2. A method as claimed in Claim 1, characterized in that the solution is prepared with the use of at least one salt of a carboxylic acid and of at least one alkoxide or with the use of at least one salt of a carboxylic acid and of at least one alkoxide and/or at least one acetyl acetonate.

3. A method as claimed in Claims 1 and 2, <u>characterized</u> in that bivalent ions in the form of salts of carboxylic acids and trivalent ions and/or ions of higher valencies in the form of alkoxides or acetyl acetonates are introduced into the solution.

4. A method as claimed in at least one of Claims 1 to 3, <u>characterized</u> in that the ferroelectric layer is formed on the first electrode in the form of a noble metal layer provided on a substrate or in the form of a polished noble metal disk as a substrate.

5. A method as claimed in Claim 4, <u>characterized</u> in that as a substrate a multilayer substrate is used in the form of a monocrystalline silicon wafer, on which an intermediate layer in the form of an oxide layer and on it a noble metal electrode layer as the first electrode are deposited, an adhesion layer favouring the adhesion of the electrode metal being provided between the oxide layer and the electrode layer.

6. A method as claimed in Claim 5, <u>characterized</u> in that the oxide layer is formed on the monocrystalline silicon substrate by thermal oxidation.

7. A method as claimed in Claims 1 to 6, <u>characterized</u> in that as the electrode metal for the first electrode platinum is used.

8. A method as claimed in Claim 7, <u>characterized</u> in that a titanium layer is provided as the adhesion layer for the electrode layer.

9. A method as claimed in at least one of Claims 1 to 8, <u>characterized</u> in that the solution forming the ferroelectric layer is applied to the first electrode by immersion or centrifuging.

10. A method as claimed in at least one of Claims 1 to 9, <u>characterized</u> in that for the solution forming the ferroelectric layer titanium tetrabutylate and barium naphthenate are used.

11. A method as claimed in at least one of Claims 1 to 10, characterized in that the second electrode is formed by a gold layer.


**Revendications**

1. Procédé de fabrication de condensateurs monocouche avec une couche ferroélectrique à base de titanate servant de diélectrique sur un support, où la couche ferroélectrique est logée entre une première et une seconde électrode en métal noble, caractérisé en ce qu'on réalise la couche ferroélectrique sous forme d'une couche de titanate de baryum d'une épaisseur qui fluctue dans la plage de 0,2 à 0,6 $\mu$m, en ce que l'on applique une solution stable de sels d'acides carboxyliques, d'alcoolates et/ou d'acétylacétonates et les décompose par voie thermique à des températures qui varient dans la plage de 500 à 700°C, où on règle la solution formatrice de la couche ferroélectrique en une manière telle que, après le processus de décomposition thermique, on obtienne un excès d'oxyde de titane d'environ 1% molaire et où on répète ce processus de revêtement ou de déposition jusqu'à obtenir l'épaisseur de couche souhaitée, puis on applique la seconde électrode à métal noble sur la couche ferroélectrique.

2. Procédé selon la revendication 1, caractérisé en ce qu'on fabrique la solution en recourant à la mise en oeuvre d'au moins un sel d'un acide carboxylique et d'au moins un alcoolate, ou en recourant à la mise en oeuvre d'au moins un sel d'un acide carboxylique et d'au moins un alcoolate et/ou d'au moins un acétylacétonate.

3. Procédé selon les revendications 1 et 2, caractérisé en ce qu'on introduit des ions bivalents sous la forme de sels d'acides carboxyliques et des ions trivalents et/ou des ions plus que trivalents sous la forme d'alcoolates ou d'acétylacétonates dans la solution.

4. Procédé selon au moins l'une des revendications 1 à 3, caractérisé en ce qu'on réalise la couche ferroélectrique sur la première électrode sous la forme d'une couche de métal noble déposée sur un support, ou sous la forme d'une plaque de métal noble polie servant de support.

5. Procédé selon la revendication 4, caractérisé en ce qu'à titre de substrat, on met en oeuvre un substrat multicouche, sous la forme d'une plaque ou galette de silicium monocristallin, sur laquelle on dépose une couche intermédiaire sous la forme d'une couche d'oxyde et par-dessus une couche d'électrode en métal noble à titre de première électrode, où on applique entre la couche d'oxyde et la couche d'électrode, une couche d'adhésivité favorisant l'adhérence du métal d'électrode.

6. Procédé selon la revendication 5, caractérisé en ce qu'on réalise la couche d'oxyde sur le support en silicium monocristallin par oxydation thermique.

7. Procédé selon les revendications 1 à 6, caractérisé en ce qu'on utilise du platine à titre de métal noble pour la première électrode.

8. Procédé selon la revendication 7, caractérisé en ce qu'on applique une couche de titane à titre de couche d'adhésivité pour la couche d'électrode.

9. Procédé selon au moins l'une des revendications 1 à 8, caractérisé en ce qu'on applique la solution formatrice de la couche ferroélectrique sur la première électrode par trempage ou centrifugation.

10. Procédé selon au moins l'une des revendications 1 à 9, caractérisé en ce qu'on utilise du tétrabutylate de titane et du naphténate de baryum pour la solution formatrice de la couche ferroélectrique.

11. Procédé selon au moins l'une des revendications 1 à 10, caractérisé en ce que la seconde électrode est formée par une couche d'or.